**Europäisches Patentamt**

**European Patent Office**

**Office européen des brevets**

(11) Numéro de publication: **0 016 295**

**A1**

# (12) DEMANDE DE BREVET EUROPEEN

(21) Numéro de dépôt: **79401041.3**

(22) Date de dépôt: **19.12.79**

(51) Int. Cl.³: **G 11 C 11/24**
**G 11 C 11/34**

(30) Priorité: **27.12.78 FR 7836545**

(43) Date de publication de la demande:
**01.10.80 Bulletin 80/20**

(84) Etats Contractants Désignés:
**BE CH DE GB IT NL SE**

(71) Demandeur: **COMPAGNIE INTERNATIONALE POUR L'INFORMATIQUE CII-HONEYWELL BULL (dite CII-HB)**
**94, avenue Gambetta**
**F-75020 Paris(FR)**

(72) Inventeur: **Mollier, Jean Henri**
**20, rue du Chemin de Fer**
**F-78380 Bougival(FR)**

(74) Mandataire: **Lincot, Georges**
**94, avenue Gambetta**
**F-75960 Paris Cedex 20(FR)**

(54) **Dispositif de test d'un caractère témoin inscrit dans une mémoire.**

(57) Le dispositif comprend, une mémoire effaçable (1), un caractère témoin (temoin) inscrit dans la mémoire, des circuits de commande (2 - 15) de la mémoire autorisant la lecture du caractère témoin et interdisant l'écriture d'informations dans la zone de la mémoire qui lui est réservée, un comparateur (16) pour vérifier la conformité du caractère témoin.

La non conformité du caractère témoin signifie que la mémoire a été exposée à des rayonnements ou à des perturbations électriques.

EP 0 016 295 A1

- 1 -

DISPOSITIF DE TEST D'UN CARACTERE TEMOIN INSCRIT DANS UNE MEMOIRE

La présente invention concerne un dispositif de test d'un caractère témoin contenu dans une mémoire effaçable composée de cellules de stockage de charges électriques, lesdites cellules étant géographiquement réparties sur un substrat dans une organisation matricielle, chaque cellule étant à la croisée d'une ligne et d'une colonne de la matrice.

Les mémoires à stockage de charges électriques sont très utilisées pour mémoriser des informations codées sous forme binaire, où l'élément d'information (bit d'information) est stocké dans la mémoire sous la forme d'une charge électrique q. Le bit d'information peut prendre deux valeurs binaires 0 à 1, ces valeurs correspondant à une charge électrique nulle ou différente de zéro.

Ces types de mémoires sont principalement réalisés à l'aide de deux types de technologie, une technologie MØS (abréviation du terme anglo-saxon Metal Oxyde Semiconducteur) et une technologie MNØS (abréviation du terme anglo-saxon Metal Nitride Oxyde Semiconducteur).

- 2 -

Une mémoire réalisée en technologie MØS a des temps d'accès de 450 à 1200 ms et des temps d'effacement de l'ordre de 1 μs alors que celle réalisée en technologie MNØS a des temps d'accès de 1 μs et des temps d'effacement de l'ordre de 1 à 100 ms. Ce qui différencie beaucoup ces deux types de réalisation tient au fait qu'une mémoire MNØS peut garder en mémoire une information pendant un temps voisin de 1 ms alors qu'une mémoire en technologie MNOS peut la conserver pendant des années. Par contre elles présentent toutes les deux l'inconvénient d'être sensibles à un certain nombre de perturbations physiques extérieures. Ainsi l'exposition de ces mémoires à des rayonnements électro-magnétiques comme les ultra-violets peuvent modifier la grandeur électrique des charges réparties dans la mémoire et par là, modifier les informations qui sont stockées. De même, des accès répétés font diminuer progressivement les quantités d'électricité stockées dans chacune de ces mémoires. Enfin, des défauts de régulation du générateur de courant et de tension alimentant les circuits de ces mémoires peuvent eux aussi perturber et modifier les informations qui sont ainsi mémorisées. On peut également citer un vieillissement prématuré affectant la permanence des informations. Ces inconvénients sont donc néfastes à l'intégrité et à la sûreté des informations ainsi mémorisées.

Naturellement, plusieurs dispositifs peuvent être utilisés pour conserver l'intégrité des informations mémorisées, en disposant par exemple des écrans absorbant les radiations néfastes, en créant des cycles de regénération des charges stockées ou en prévoyant des dispositifs de coupe circuit d'alimentation lorsque celle-ci devient défaillante. Malgré la qualité de ces dispositifs rendant pratiquement inaltérable les informations contenues dans ces mémoires, on ne peut jamais être certain qu'une mémoire n'a pas été exposée un certain moment à un rayonnement ou qu'un phénomène électrique s'est produit qui aurait eu pour conséquence une altération des informations mémorisées.

Le but de l'invention est de prévoir un dispositif permettant de contrôler qu'il n'y a pas eu de modifications des informations contenues dans la mémoire par d'autres voies que celles autorisées par les circuits permettant l'accès normal à ces informations et de dénoncer une exploration indiscrète de la mémoire.

Le dispositif selon l'invention pourra être réalisé si la mémoire possède un caractère témoin pré-enregistré avant l'utilisation normale de la mémoire dans une zone prévue à cet effet et si les circuits de commande de la mémoire sont réalisés de telle sorte qu'une lecture du caractère témoin dans cette zone soit toujours possible et que par contre l'écriture d'autres informations dans cette zone en soit interdite.

Le dispositif selon l'invention devra donc être capable de lire le caractère témoin dans la zone mémoire qui lui a été réservée et devra vérifier que ce caractère témoin après usage n'a pas été altéré.

Ainsi défini, le dispositif selon l'invention est un dispositif de test d'un caractère témoin ayant un code binaire prédéfini et pré-enregistré dans une zone de mémoire effaçable à stockage de charges électriques, ladite mémoire étant associée à des moyens de commande autorisant la lecture du caractère témoin dans la zone qui lui est réservée et interdisant l'écriture d'information dans ladite zone, ledit dispositif étant caractérisé en ce qu'il comprend un moyen de comparaison du caractère témoin lu à partir des moyens de commandes, au code binaire prédéfini lors de l'enregistrement du caractère témoin à l'intérieur de ladite mémoire.

Si le caractère témoin a une fragilité plus grande que le reste des autres zones de la mémoire, il sera détérioré avant les autres informations contenues dans la mémoire. Il sera avantageux de procéder systématiquement avant chaque lecture dans la mémoire, à un test des informations composant le caractère témoin pour vérifier que la mémoire n'a pas été plongée dans un milieu hostile et de s'assurer que les informations contenues dans la mémoire peuvent ou non être utilisées. Ainsi définie, l'invention peut être appliquée dans tous les systèmes de traitement de données, gros ordinateurs ou équipement de poche, où il est nécessaire de garantir à tout moment l'intégrité des informations.

D'autres caractéristiques et avantages de l'invention apparaîtront mieux à l'aide de la description et des dessins qui vont suivre.

La figure 1 représente sous forme simplifiée une cellule mémoire à stockage de charge électrique.

Les figures 2A, 2B et 2C représentent le schéma de

- 5 -

cellules mémoire réalisées respectivement en technologie MØS et en technologie MNØS.

La figure 3 est un schéma montrant l'appareillage nécessaire à l'introduction du caractère témoin dans une mémoire à stockage de charge.

La figure 4 est un schéma montrant une mémoire à stockage de charge dans laquelle un caractère témoin est inscrit et à laquelle sont adjoint des circuits de commande autorisant l'accès du caractère témoin en mode lecture et l'interdisant en mode écriture ainsi que le dispositif de test du caractère témoin selon l'invention.

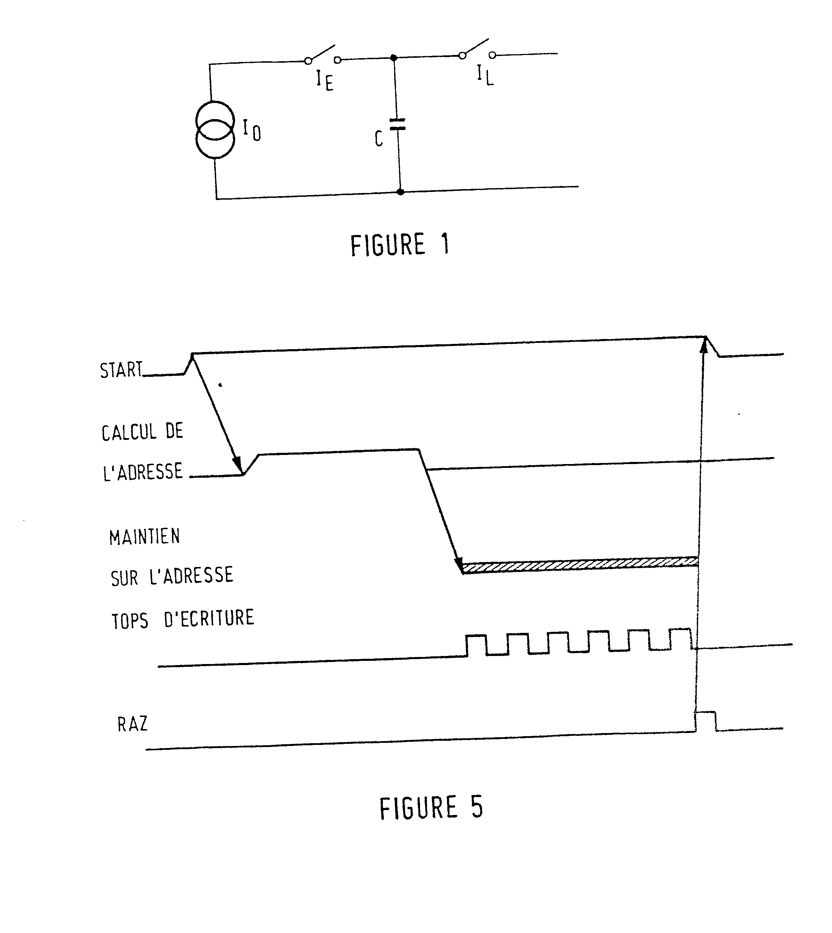

La cellule à stockage de charge de la figure 1 se compose d'un condensateur C alimenté au travers d'un interrupteur $I_E$ par un générateur de courant $I_O$. Lorsque l'interrupteur $I_E$ est fermé, le courant délivré par le générateur de courant $I_O$ circule dans le condensateur C et charge ce condensateur d'une quantité d'électricité $\Delta Q$ qui dépend du temps $\Delta t$ pendant lequel l'interrupteur $I_E$ est fermé suivant la relation $\Delta Q = I_O \Delta t$. Dans le cas où il est donné une valeur constante au courant $I_O$ et au lapse de temps $\Delta t$, la quantité d'électricité ainsi introduite dans le conducteur C se trouve être constante. En répétant ainsi $n_1$ fois les instants de fermeture de l'interrupteur $I_E$, on stocke une charge $Q_1 = n_1 I_O \Delta t$ dans le condensateur C. Dans l'aplication qui intéresse l'invention, il est nécessaire de charger les cellules de stockage composant le caractère témoin d'une quantité d'électricité inférieure à celle utilisée pour mémoriser les informations autres que celles figurant dans le caractère témoin. Selon le principe qui vient d'être exposé, ce problème peut être résolu en chargeant les cellules de stockage réservées au caractère témoin d'une quantité d'électricité $Q_1 = n_1I_0 \Delta t$ et les cellules autres d'une quantité d'électricité $Q_2 = n_0I_0\Delta t$ où $n_2$ correspond au nombre de répétition des instants de fermeture de l'interrupteur $I_E$. Le nombre $n_2$ devra être supérieur au nombre $n_1$ pour que la quantité d'électricité $Q_1$ soit inférieure à la quantité d'électricité $Q_2$. Les cellules, une fois chargées des quantités d'électricité $Q_1$, $Q_2$ présentent alors aux bornes de la capacité C les différences de potentiels $U_{L1} = \dfrac{Q1}{C}$ et $U_{L2} = \dfrac{Q2}{C}$ où $U_{L2}$ > $U_{L1}$. Ces différences de potentiel peuvent alors être lues par des circuits extérieurs par fermeture de l'interrupteur $I_L$. Il est bien évident que dans un autre mode de réalisation non décrit ici, il serait aussi possible d'obtenir les deux charges $Q_1$ et $Q_2$ par application de deux tensions $U_1$ et $U_2$ différentes.

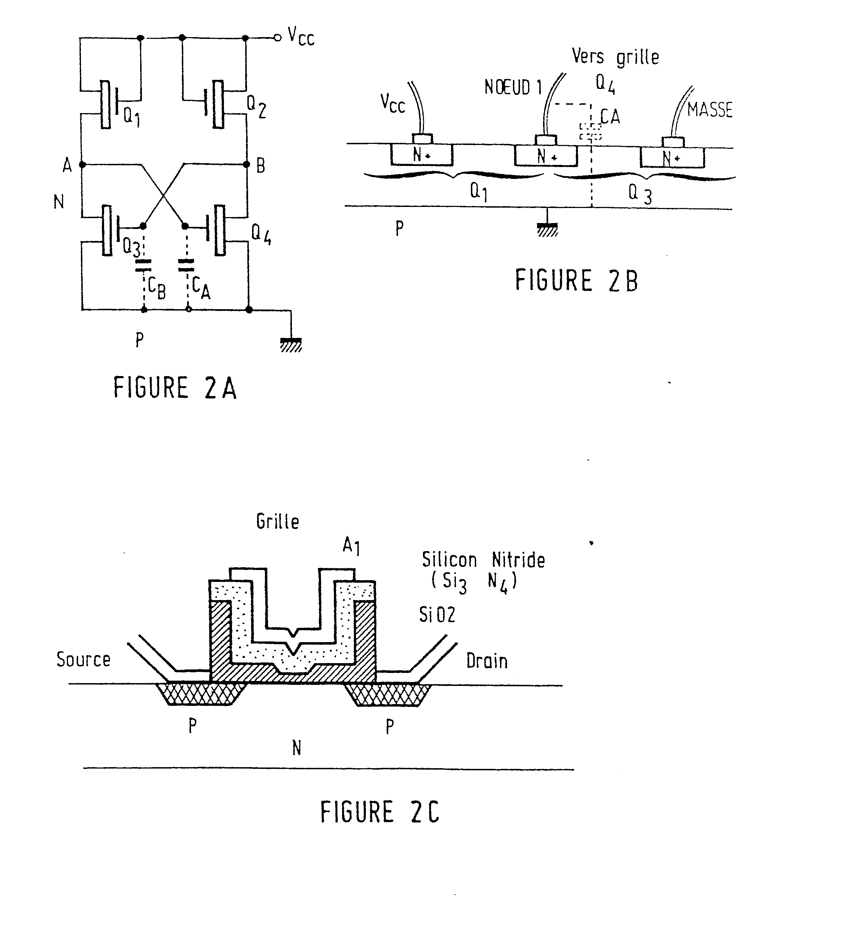

Les figures 2A et 2B représentent des modes de réalisations différentes de ces cellules.

La cellule mémoire représentée à la figure 2A comprend quatre transistors. Les transistros $Q_1$ et $Q_2$ sont utilisés comme charge résistive tandis que les transistors $Q_3$ et $Q_4$ sont rétrocouplés. Une information est mémorisée dans une des branches ($Q_1$, $Q_3$) ou ($Q_2$, $Q_4$) lorsque les transistors de l'autre branche conduisent. Cette information est conservée en l'absence de tension d'alimentation $V_{cc}$ par les capacités parasites $C_A$ ou $C_B$ de grille. Dans une réalisation en technologie MØS ses capacités se déchargent lentement dans la jonction constituée par la zone de diffusion N au niveau des noeuds A ou B et le substrat P qui est au potentiel de la masse (figure 2B). L'effet de décharge peut être éliminépar utilisation de transistor MNØS dont la constitution est montrée à la figure 2C. Sur cette figure le substrat a une conductibilité de type N et comporte deux zones de diffusion P, l'une étant reliée à l'électrode de source et l'autre à celle de drain. Sur la surface du substrat N entre les deux zones de diffusion P sont déposées successivement : une couche d'oxyde de silicium $SiO_2$, une couche de nitride de silicium $Si_3N_4$ et une couche d'aluminium.

Lorsque ce type de transistor est normalement polarisé par des générateurs de courant et de tensions extérieures , les charges électriques circulent des zones de diffusion P vers la grille au travers de la couche très mince de $SiO_2$. Un effet tunnel se produit qui bloque ces charges électriques dans la couche de nitrure de silicium. En l'absence de toute alimentation par les générateurs extérieurs, ces charges restent localisées au niveau de la couche de nitrure de silicium.

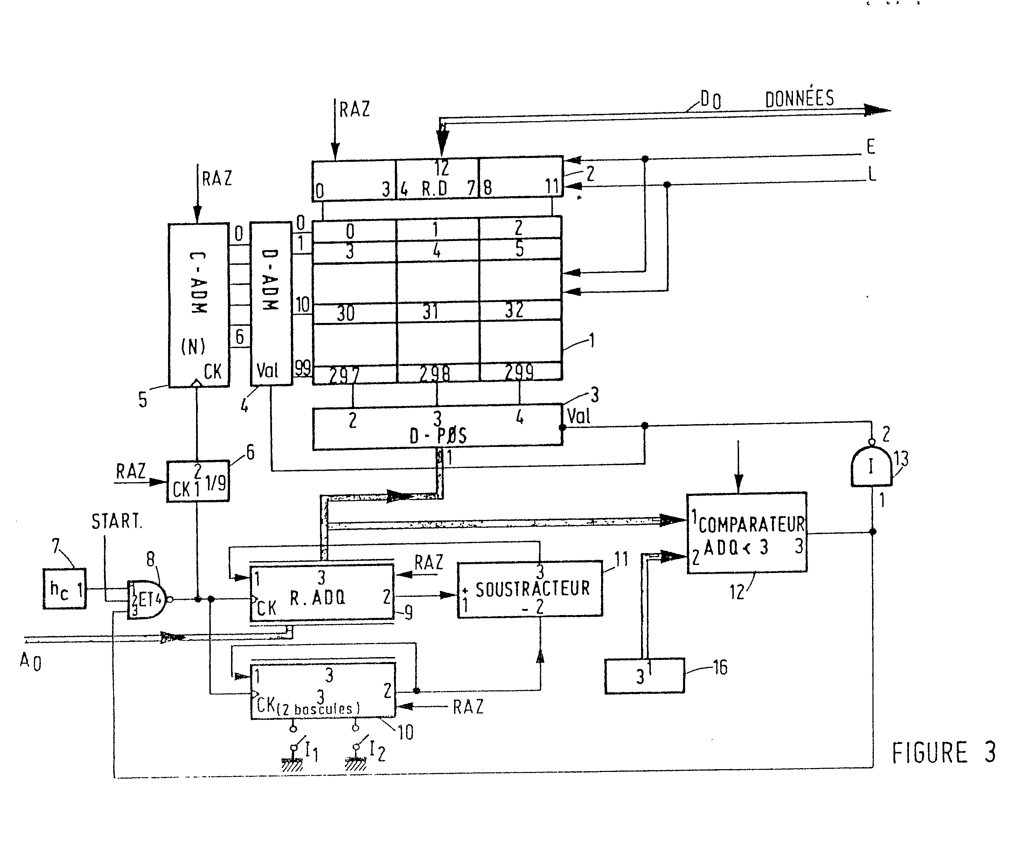

L'introduction d'un caractère témoin à l'intérieur d'une mémoire à stockage de quantité d'électricité a lieu avec le dispositif représenté à la figure 3. Sur cette figure, la mémoire de stockage 1 est une mémoire à 100 lignes et 12 colonnes réalisant une capacité de 1200 cellules de stockage. Dans l'exemple de réalisation qui est montré la mémoire est divisée en 300 emplacements de 4 bits allant du chiffre 0 au chiffre 299, les chiffres 0 1 2 se suivent sur la ligne 0, les chiffres 3 4 5 sur la ligne 1 et ainsi de suite... Les 100 lignes sont sélectionnées à partir du décodeur d'adresse DADM 4. La position d'un emplacement de 4 bits est sélectionnéé sur une ligne à partir du décodeur de position D.PØS 3. Le décodeur D.ADM4 décode les combinaisons des sorties O à 6 du compteur binaire C.DAM5. Ce compteur progresse à partir des signaux binaires arrivant sur son entrée $C_K$ et générés par la sortie 2 d'un compteur 6 à quatre bascules qui est lui-même piloté sur son entrée $C_K$ par les signaux d'horloge générés par la sortie 4 de la porte ET 2.

Le registre RADQ 9 est un registre à décalage à 9 bascules qui contient l'adresse binaire de l'emplacement de mémoire de 4 bits à sélectionner. Il reçoit sur son entrée $C_K$ les signaux d'horloge générés par la porte ET 8. A l'initialisation ce registre est chargé par les bits d'adresse positionné sur la ligne d'adresse $A_0$. La sortie 2 du registre R ADQ est reliée à l'entrée 1 du soustracteur 11. Le registre 10 est aussi un registre à décalage à 9 bascules piloté lui aussi par les signaux d'horloge sortant de la porte ET 8 et émis sur son entrée $C_K$. Ce registre est chargé à l'initialisation par le nombre 3 à l'aide de deux interrupteurs $I_0$ à $I_8$. Sa sortie 2 est reliée à l'entrée 2 du soustracteur 11. La sortie 2 du registre 10 est rebouclée sur son entrée 1 de manière qu'en cours de décalage les bits de sortie se retrouvent réinjectés à son entrée. Le soustracteur 11 opère la soustraction bit à bit des contenus du registre R ADQ 9 et du registre 1C. Le résultat qui apparaît sur sa sortie 3 est réinjecté à l'entrée 1 du registre R ADQ. De cette façon, le registre R ADQ contient à la fin de l'opération de soustraction la valeur de l'adresse de début d'opération diminué de 3 unités. Le comparateur 12 signale sur sa sortie 3 que le contenu du registre R

ADQ est inférieur au nombre décimal 3. Ce comparateur est relié par son entrée 1 à la sortie du registre R ADQ et sur son entrée 2 au registre 10 délivrant sur sa sortie 3 la combinaison binaire 0.000.000.011 correspondant au nombre décimal 3. La sortie 3 du comparateur 12 est appliqué d'une part à l'entrée 3 de la porte ET 8 et d'autre part à l'entrée 1 de l'inverseur 13 dont la sortie 2 est reliée aux entrées de validation du décodeur de position 3 et du décodeur d'adresse mémoire D ADM 4. La porte ET 8 reçoit sur son entrée 1 les signaux délivrés par le générateur d'horloge 7 et sur son entrée 2 le signal "start" qui commande toute l'opération d'adressage. La mémoire 1 est reliée à un registre de données RD2 qui contient les informations à écrire ou à lire dans la mémoire à l'adresse calculée par les moyens d'adressage. Ce registre est relié aux organes extérieurs par la ligne de données DO. La mémoire 1 et le registre RD sont commandés en écriture et en lecture par les signaux E et $L_1$.

Le fonctionnement du dispositif fait à l'aide du chronogramme de la figure 5 est le suivant. A l'initialisation, l'adresse du caractère témoin est introduite en binaire dans le registre R ADQ 9 ainsi qu'est interdit le nombre décimal 3 dans le registre 10. L'initialisation étant terminée, le calcul d'adresse est alors effectué par application du signal "start" sur l'entrée 2 de la porte ET 8. L'ensemble constitué par le registre R ADQ 9, le registre 10 et le soustracteur 11 effectue l'opération ADQ = ADQ − 3 toutes les 9 impulsions d'horloge. En même temps toutes les 9 impulsions d'horloge le compteur CADM progresse d'un pas. Ce cycle se produit jusqu'à ce que le contenu du registre ADQ devienne inférieur au nombre décimal 3. Lorsque cette condition est réalisée le compteur CADM contient l'adresse ligne de l'emplacement mémoire recherché et le compteur R ADQ contient l'adresse Position (PØS) de cet emplacement. L'écriture du caractère témoin à l'emplacement ainsi sélectionné peut alors avoir lieu en envoyant sur la ligne E un nombre déterminé de "tops" d'écriture durant l'intervalle séparant la fin du calcul de l'adresse jusqu'à la retombée du signal "start". De cet intervalle dépend naturellement la durée du temps de charge des cellules de mémoire composant le caractère témoin et par là même sa fragilité.

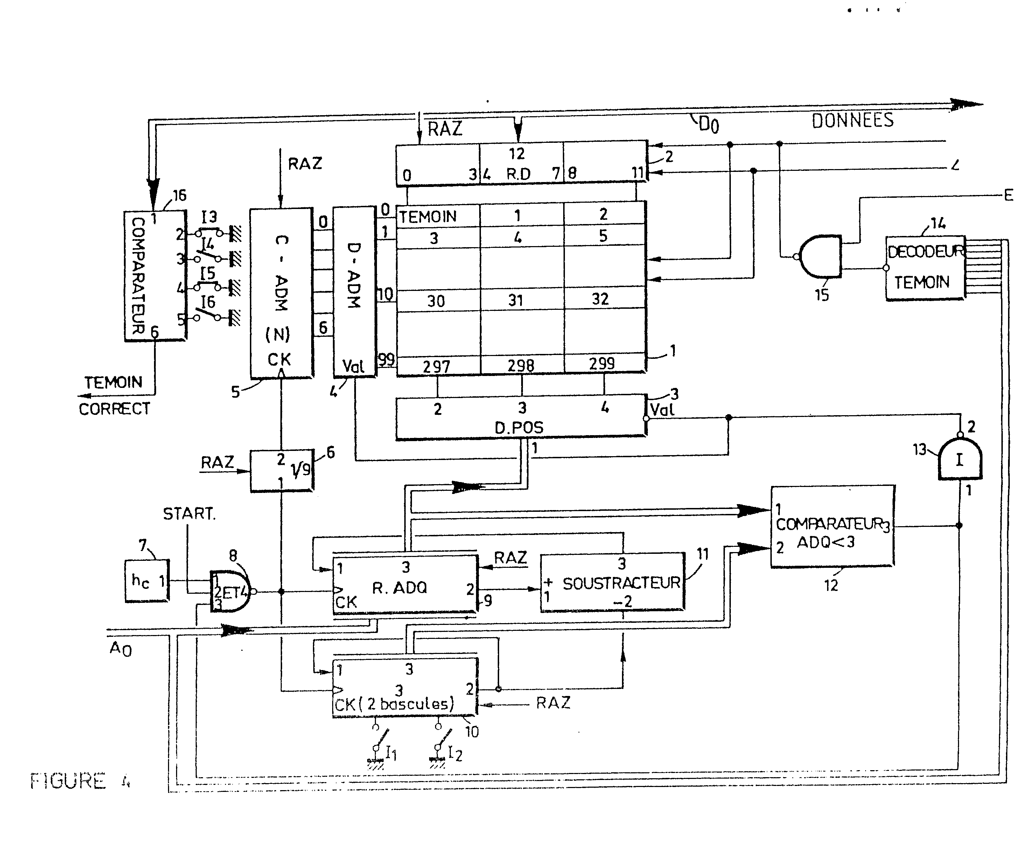

L'introduction du caractère témoin dans la mémoire a lieu en fabrication avant l'assemblage du module de mémoire avec le restant des circuits qui devront, lorsque le produit sera fini, coopérer avec cette mémoire. Il est nécessaire, lorsque le produit sera fini, d'interdire des écritures d'information intempestives à l'intérieur de la zone témoin. La figure 4 montre le dispositif qui devra nécessairement être ajouté en cours de fabrication au circuit d'adressage de la mémoire et après inscription du caractère témoin. Il se compose du décodeur 14 et de la porte "ET 15". Les entrées du décodeur 14 sont reliées à la ligne d'adresse $A_0$, sa sortie est reliée à une entrée de la porte "ET" 15 à 2 entrées dont l'autre entrée reçoit le signal d'écriture E et dont la sortie place le registre de donnée RD et la mémoire 1 en mode "écriture". Ainsi lorsqu'apparaît sur la ligne d'adresse $A_0$, une combinaison binaire correspondant à celle définissant l'adresse du caractère témoin, l'écriture dans la mémoire et dans le registre $RD_2$ se trouve interdite. Ce dispositif interdit donc l'écriture dans la zone témoin mais n'empêche pas la lecture de cette zone. Le comparateur 16 a ses entrées 1 reliées à la ligne de donnée $D_0$ et reçoit sur ses entrées 2 à 5 les bits d'informations correspondant au code prédéfini et préenregistré dans la zone témoin de la mémoire. Ce code est introduit sur les entrées 2 à 5 par les interrupteurs $I_3$ à $I_6$. Lorsqu'une lecture du contenu de la zone témoin de la mémoire 1 est effectuée, le caractère témoin est déposé sur la ligne de donnée $D_0$ et est comparé par le comparateur 16 aux bits d'information présents sur les entrées 2 à 5. S'il y a égalité entre l'information présente sur la ligne $D_0$ et celle présente sur les entrées 2 à 5 un signal binaire est émis à la sortie 6 du comparateur 16. Le témoin lu est déclaré correct. S'il n'y a pas égalité le signal binaire est émis à la sortie 6 du comparateur 16 prend une valeur binaire opposée, le témoin est déclaré incorrect et par conséquent les informations contenues dans la mémoire 1 sont supposées avoir été altérées.

Sur la figure 4, les circuits d'adressage déjà mentionnés au cours de la description de la figure 3 ont été à nouveau représentés. En effet, rien ne s'oppose à ré-utiliser les mêmes circuits d'adressage pour la confection du produit que ceux utilisés en cours de fabrication pour l'inscription du caractère témoin.

L'exemple qui vient d'être donné d'une réalisation préférée de l'invention n'est nullement limitatif, il est bien évident que l'homme de l'art bien au fait des techniques de traitement de l'information pourra concevoir d'autres modes de réalisation sans pour autant sortir de son cadre.

REVENDICATIONS

1. Dispositif de test d'un caractère témoin ayant un code binaire prédéfini, et préenregistré dans une zone de mémoire effaçable à stockage de charges électriques pour garantir l'intégrité des informations contenues dans une mémoire, ladite mémoire étant associée à des moyens de commande autorisant la lecture du caractère témoin dans la zone qui lui est réservée et interdisant l'écriture d'information dans ladite zone caractérisé en ce qu'il comprend un moyen de comparaison du caractère témoin lu à partir des moyens de commandes, au code binaire prédéfini lors de l'enregistrement du caractère témoin à l'intérieur de ladite zone de mémoire.

2. Dispositif de test d'un caractère témoin selon la revendication 1 caractérisé en ce que les moyens de commande de la mémoire se composent de moyens d'adressage de la mémoire associés à un décodeur invalidant la commande d'écriture de la mémoire lorsque l'adresse de la zone témoin est présente à l'entrée des circuits d'adressage de la mémoire.

FIGURE 1

START

CALCUL DE

L'ADRESSE

MAINTIEN

SUR L'ADRESSE

TOPS D'ECRITURE

RAZ

FIGURE 5

FIGURE 2A

FIGURE 2B

FIGURE 2C

FIGURE 3

FIGURE 4

**Office européen des brevets**

# RAPPORT DE RECHERCHE EUROPEENNE

Numéro de la demande

EP 79 40 1041

| | DOCUMENTS CONSIDERES COMME PERTINENTS | | CLASSEMENT DE LA DEMANDE (Int. Cl) |
|---|---|---|---|
| Catégorie | Citation du document avec indication, en cas de besoin, des parties pertinentes | Revendica-tion concernee | |
| | IBM TECHNICAL DISCLOSURE BULLETIN, vol. 20, no. 11A, avril 1978, New York, US JOHNSON & STINSON: "Master storage cell to initiate refreshing of dynamic memory chip", pages 4401-4403. <br><br> * Article complet * <br><br> ---- | 1 | G 11 C 11/24 <br> 11/34 |

**DOMAINES TECHNIQUES RECHERCHES (Int. Cl.)**

G 11 C 11/24
11/34

**CATEGORIE DES DOCUMENTS CITES**

X. particulièrement pertinent
A: arrière-plan technologique
O. divulgation non-écrite
P: document intercalaire
T: théorie ou principe à la base de l'invention
E: demande faisant interférence
D document cité dans la demande
L document cité pour d'autres raisons

&. membre de la même famille document correspondant

Le présent rapport de recherche a été établi pour toutes les revendications

| Lieu de la recherche | Date d'achèvement de la recherche | Examinateur |
|---|---|---|
| La Haye | 11-04-1980 | DEGRAEVE |